# EUROPEAN PATENT APPLICATION

(11) **EP 4 164 359 A1**
(43) Date of publication of application: **12.04.2023**
(21) Application number: 22200366.7
(22) Date of filing: 07.10.2022
(51) Int. Cl.: H10K 50/844, H10K 59/40

(54) **ELECTRONIC DEVICE**

(30) Priority: 08.10.2021 KR 20210133700
(71) Applicant: Samsung Display Co., Ltd., Gyeonggi-Do (KR)
(72) Inventor: NISHIZAKI, Shogo, Seoul (KR); KIM, Jaehyun, Suwon-si (KR); CHOI, Young Seo, Yongin-si (KR)
(74) Representative: Marks & Clerk LLP

(57) **Abstract**

An electronic device includes: a base layer; a circuit layer on the base layer; a light-emitting element layer on the circuit layer; and an encapsulation layer including a first barrier layer on the light-emitting element layer and having at least one of silicon oxycarbide or silicon oxide, and a second barrier layer on top of the first barrier layer and having at least one of silicon oxynitride or silicon nitride, wherein the content of a Carbon (C) element is in a range of 0% to 10% with respect to the total content of the first barrier layer.

## Description

### BACKGROUND

Aspects of some embodiments of the present disclosure herein relate to an electronic device.

An electronic device includes an active region that may be activated in response to electrical signals. An electronic device may sense input applied from the outside at the active region, and may display various images to provide information to users.

Meanwhile, an electronic device may include a light-emitting element that uses an organic electroluminescent material or a quantum dot light-emitting material. Such a light-emitting element has characteristics that are vulnerable to external contaminants such as oxygen and moisture, and thus various techniques may be utilized to seal the light-emitting element from external contaminants. Among the techniques, according to some embodiments an encapsulation layer may be located on a light-emitting element to block the penetration path of air and moisture.

The above information disclosed in this Background section is only for enhancement of understanding of the background and therefore the information discussed in this Background section does not necessarily constitute prior art.

### SUMMARY

Aspects of some embodiments of the present disclosure herein relate to an electronic device, and for example, to an electronic device including an encapsulation layer that covers a display element layer.

Aspects of some embodiments of the present disclosure include an electronic device including an encapsulation layer with improved flatness and barrier characteristics by including a barrier layer that replaces an organic layer.

According to some embodiments of the present disclosure, an electronic device includes: a base layer; a circuit layer located on the base layer; a light-emitting element layer located on the circuit layer; and an encapsulation layer including a first barrier layer located on the light-emitting element layer and having at least one of silicon oxycarbide or silicon oxide, and a second barrier layer located on top of the first barrier layer and having at least one of silicon oxynitride or silicon nitride, wherein the content of a C element is about 0% to about 10% with respect to the total content of the first barrier layer.

According to some embodiments, a first thickness of the first barrier layer may be greater than a second thickness of the second barrier layer.

According to some embodiments, the first thickness may be about 3 µm to about 10 µm.

According to some embodiments, with respect to the total content of the first barrier layer, a Si element may be included in an amount of about 30% to about 50%, and an O element may be included in an amount of about 50% to about 60%.

According to some embodiments, when seen in a plan view parallel to the base layer, an edge of the second barrier layer may be located outside an edge of the first barrier layer.

According to some embodiments, when seen in a plan view parallel to the base layer, an area of the second barrier layer may be larger than an area of the first barrier layer.

According to some embodiments, a refractive index of the second barrier layer may be greater than a refractive index of the first barrier layer.

According to some embodiments, the encapsulation layer may further include an optical control layer located between the light-emitting element layer and the first barrier layer, and having two or more inorganic layers having different refractive indices.

According to some embodiments, the optical control layer may include: a first inorganic layer including silicon oxynitride and having a first refractive index; a second inorganic layer located on top of the first inorganic layer, including silicon nitride, and having a second refractive index greater than the first refractive index; a third inorganic layer located on top of the second inorganic layer, including silicon oxynitride, and having a third refractive index smaller than the second refractive index; and a fourth inorganic layer located on top of the third inorganic layer, including silicon oxynitride, and having a fourth refractive index smaller than the third refractive index.

According to some embodiments, the optical control layer and the first barrier layer may be successively deposited in the same chamber, and the second barrier layer and the first barrier layer may be deposited in different chambers.

According to some embodiments, the light-emitting element layer may include a pixel defining layer and a light-emitting element including a functional layer located in an opening defined in the pixel defining layer, and the first barrier layer may cover a top surface of the light-emitting element layer.

According to some embodiments, a top surface of the first barrier layer may be a flat surface, and the first barrier layer may fill a space between the light-emitting element layer and the second barrier layer.

According to some embodiments, the electronic element may further include a sensor layer located on the encapsulation layer, wherein the sensor layer may be directly located on the second barrier layer.

According to some embodiments, the base layer may include an active region overlapping the light-emitting element layer; and a peripheral region adjacent to the outside of the active region and non-overlapping the light-emitting element layer, the peripheral region may include a first peripheral portion adjacent to the active region, and a second peripheral portion spaced apart from the active region and adjacent to the first peripheral portion, the first peripheral portion overlaps the first barrier layer and the second barrier layer, and the second peripheral portion may not overlap the first barrier layer and may overlap the second barrier layer.

According to some embodiments, a plurality of insulating layers included in the circuit layer may be stacked and located on the second peripheral portion, and the second barrier layer may be directly located on the uppermost layer of the plurality of insulating layers in the second peripheral portion.

According to some embodiments of the present disclosure, in an electronic device having an active region and a peripheral region located outside the active region, the electronic device includes: a base layer; a circuit layer located on the base layer; a light-emitting element layer located on the circuit layer; and an encapsulation layer located on the light-emitting element layer, wherein the encapsulation layer includes a first barrier layer configured to cover an uneven top surface of the light-emitting element layer, and a second barrier layer located on the first barrier layer, and the first barrier layer includes at least one of silicon oxycarbide or silicon oxide, and the content of a C element is about 0% to about 10% with respect to the total content of the first barrier layer.

According to some embodiments, with respect to the total content of the first barrier layer, a Si element content may be about 30% to about 50%, and an O element content may be about 50% to about 60%.

According to some embodiments, the first barrier layer may have a thickness of about 3 µm to about 10 µm, and the second barrier layer may have a thickness of about 1 µm or less.

According to some embodiments, the encapsulation layer may further include an optical control layer located between the light-emitting element layer and the first barrier layer, and including a plurality of inorganic layers having different refractive indices.

According to some embodiments, wherein the light-emitting element layer may be arranged to correspond to the active region, the encapsulation layer may cover the light-emitting element layer and may be arranged to extend to the peripheral region, and an edge of the second barrier layer may be further spaced apart from the active region than an edge of the first barrier layer.

At least some of the above and other features of the invention are set out in the claims.

### BRIEF DESCRIPTION OF THE FIGURES

The accompanying drawings are included to provide a further understanding of embodiments according to the present disclosure, and are incorporated in and constitute a part of this specification. The drawings illustrate aspects of some embodiments of the inventive concept and, together with the description, serve to explain principles of the inventive concept. In the drawings:
FIG. 1 is a perspective view of an electronic device according to some embodiments;
FIG. 2 is an exploded perspective view of an electronic device according to some embodiments;
FIG. 3 is a cross-sectional view of a display module according to some embodiments;
FIG. 4 is a cross-sectional view of a portion of a display module according to some embodiments;
FIG. 5 is a cross-sectional view of a portion of a display module according to some embodiments;
FIG. 6 is a cross-sectional view illustrating a portion of a display module according to some embodiments;
FIG. 7 is a plan view of a display module according to some embodiments;
FIG. 8 is a cross-sectional view illustrating a portion of a display module according to some embodiments;
FIG. 9 is a cross-sectional view illustrating a portion of a display module according to some embodiments;
FIG. 10 is a cross-sectional view illustrating a portion of a display module according to some embodiments; and
FIG. 11 is an image showing a cross section of a test sample provided with a barrier layer according to some embodiments.

### DETAILED DESCRIPTION

The present invention may be implemented in various modifications and have various forms and specific embodiments are illustrated in the drawings and described in detail in the text. It is to be understood, however, that the invention is not intended to be limited to the particular forms disclosed, but on the contrary, is intended to cover all modifications, equivalents, and alternatives falling within the scope of the invention.

It will be understood that when an element or layer is referred to as being "on", "connected to" or "coupled to" another element or layer, it can be directly on, connected or coupled to the other element or layer or intervening elements or layers may be present. In contrast, when an element is referred to as being "directly on," "directly connected to" or "directly coupled to" another element or layer, there are no intervening elements or layers present.

On the other hand, in the present application, "directly disposed" or "directly located" or "directly arranged" (or any other similar terminology) means that there is no layer, film, region, plate, or the like added between the portion of the layer, film, region, for example, "directly arranged" may mean arranging without additional members such as adhesive members between two layers or two members.

Like reference numerals or symbols refer to like elements throughout. The thickness and the ratio and the dimension of the element are exaggerated for effective description of the technical contents.

As used herein, the term "and/or" includes any and all combinations of one or more of the associated listed items.

It will be understood that, although the terms first, second, etc. may be used herein to describe various elements, components, regions, layers and/or sections, these elements, components, regions, layers and/or sections should not be limited by these terms. These terms are only used to distinguish one element, component, region, layer or section from another region, layer, or section. Thus, a first element, component, region, layer, or section discussed below could be termed a second element, component, region, layer, or section without departing from the teachings of the present invention.

Spatially relative terms, such as "beneath", "below", "lower", "above", "upper" and the like, may be used herein for ease of description to describe one element or feature's relationship to another element(s) or feature(s) as illustrated in the figures. It will be understood that the spatially relative terms are intended to encompass different orientations of the device in use or operation in addition to the orientation depicted in the figures. In this specification, the wording "located on" may mean a case of being located not only on the upper part of any one member but also on the lower part.

Unless otherwise defined, all terms (including technical and scientific terms) used herein have the same meaning as commonly understood by one of ordinary skill in the art to which this invention belongs. It will be further understood that terms, such as those defined in commonly used dictionaries, should be interpreted as having a meaning that is consistent with their meaning in the context of the relevant art and will not be interpreted in an idealized or overly formal sense unless expressly so defined herein.

It will be further understood that the terms "includes" and/or "including", when used in this specification, specify the presence of stated features, integers, steps, operations, elements, and/or components, but do not preclude the presence or addition of one or more other features, integers, steps, operations, elements, components, and/or groups thereof.

Hereinafter, an electronic device according to some embodiments of the inventive concept will be described with reference to the drawings.

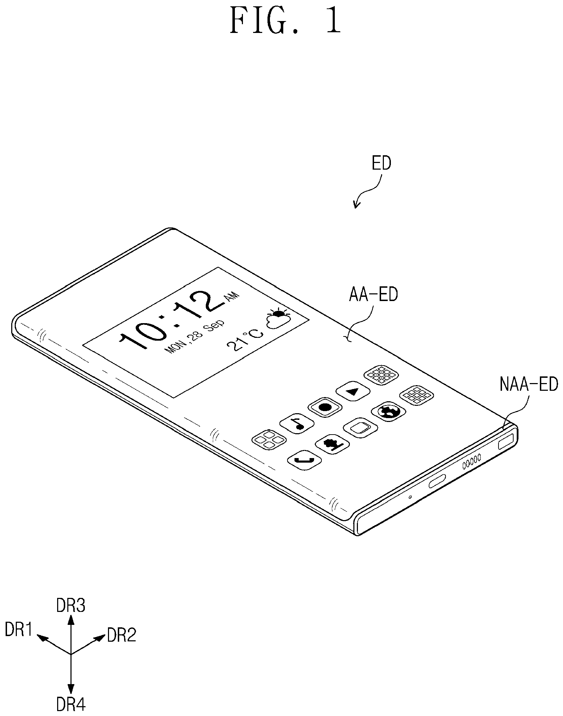

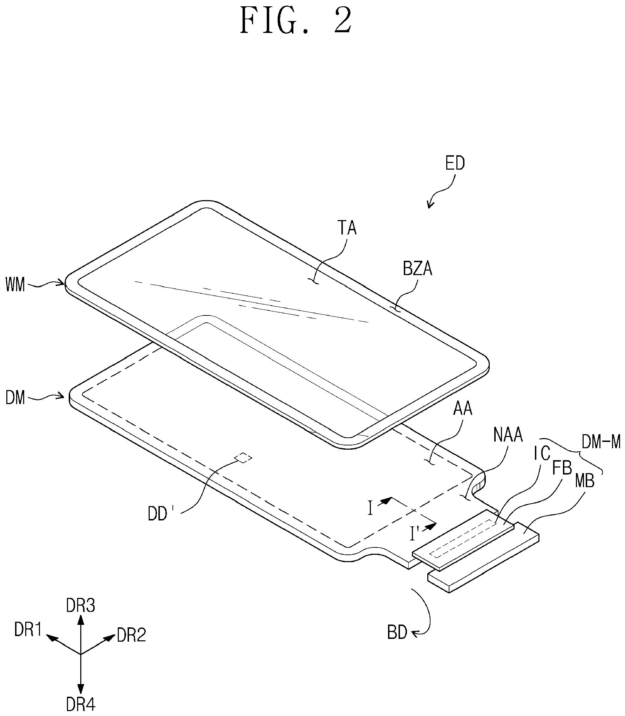

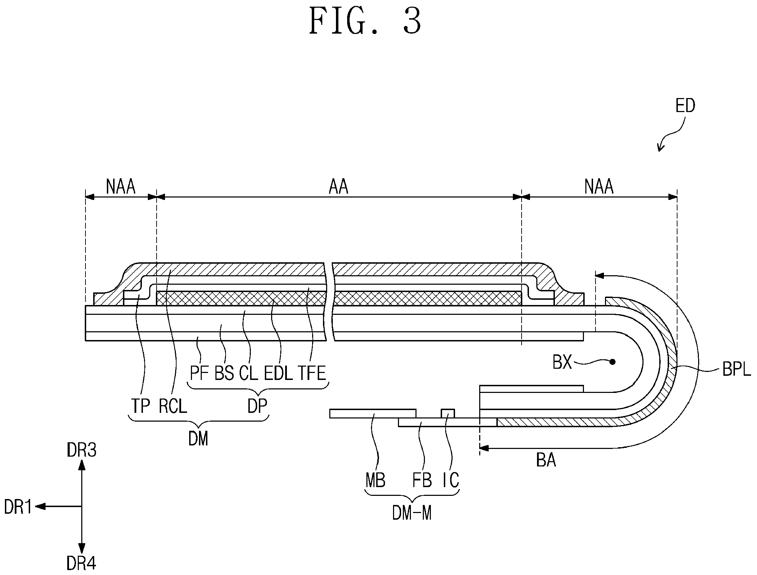

FIG. 1 is a perspective view of an electronic device according to some embodiments. FIG. 2 is an exploded perspective view of an electronic device according to some embodiments. FIG. 3 is a cross-sectional view of a display module according to some embodiments.

The electronic device ED according to some embodiments as illustrated in FIGS. 1 to 3 may be a device activated in response to electrical signals. For example, the electronic device ED may be a mobile phone, a tablet computer, a car navigation system, a game machine, or a wearable device, but embodiments according to the present disclosure are not limited thereto. For purposes of illustration, in FIG. 1, a mobile phone is illustrated as an example of the electronic device ED, but the electronic device ED may be any suitable electronic device having display and input functionality according to the design and application of the electronic device ED.

Referring to FIGS. 1 to 3, the electronic device ED according to some embodiments may include an active region AA-ED and an inactive region NAA-ED which may surround at least one side of the active region AA-ED. However, the present disclosure is not limited thereto, and in some embodiments, the inactive region NAA-ED may be omitted. The electronic device ED according to some embodiments may display images at the active region AA-ED. The active region AA-ED may include a plane defined by a first direction axis DR1 and a second direction axis DR2. The active region AA-ED may further include a curved surface bent from at least one side of the plane defined by the first direction axis DR1 and the second direction axis DR2. FIG. 1 illustrates that the electronic device ED according to some embodiments includes two curved surfaces respectively bent from both sides of the plane defined by the first direction axis DR1 and the second direction axis DR2. However, the shape of the active region AA-ED is not limited thereto. For example, the active region AA-ED may include only the plane, and the active region AA-ED may further include four curved surface respectively bent from at least two sides of the plane, for example, from four sides, or the active region AA-ED may include various other shapes or configurations (e.g., a foldable or bendable configuration) without departing from the scope of embodiments according to the present disclosure.

Meanwhile, in FIG. 1 and subsequent drawings, a first direction axis DR1 to a fourth direction axis DR4 are illustrated, and directions indicated by the first to fourth direction axes DR1, DR2, DR3, and DR4 described herein are relative concepts and may thus be changed into other directions. In addition, directions indicated by the first to fourth direction axes DR1, DR2, DR3, and DR4 may be described as first to fourth directions, and may be denoted as the same reference numerals or symbols.

In this specification, the first direction axis DR1 and the second direction axis DR2 may be orthogonal to each other, and the third direction axis DR3 may be a normal direction of the plane defined by the first direction axis DR1 and the second direction axis DR2. The fourth direction axis DR4 may be a normal direction of the plane defined by the first direction axis DR1 and the second direction axis DR2, and may be a direction opposite to the direction of the third direction axis DR3.

The thickness direction of the electronic device ED may be parallel to the third direction axis DR3, which is a normal direction of the plane defined by the first direction axis DR1 and the second direction axis DR2. In this specification, the front surface (or top surface) and the rear surface (or bottom surface) of each member constituting the electronic device ED may be defined based on the third direction axis DR3.

The electronic device ED according to some embodiments may include a display module DM. The display module DM may be configured to generate images and may further be configured to sense an input (e.g., a touch or proximity input, for example, from a user's finger, a stylus, etc.) applied from the outside. The display module DM according to some embodiments includes a display layer DP. The display module DM according to some embodiments may further include a sensor layer TP located on the display layer DP, and an optical layer RCL located on the sensor layer TP. However, embodiments of the inventive concept are not limited thereto, and according to some embodiments, the sensor layer TP or the optical layer RCL may be omitted.

An active region AA and a peripheral region NAA may be defined in the display module DM. The active region AA may be a region activated in response to an electrical signal. The peripheral region NAA may be a region adjacent to at least one side of the active region AA.

The active region AA may correspond to the active region AA-ED of the electronic device ED illustrated in FIG. 1. The peripheral region NAA may be arranged to surround the active region AA. The peripheral region NAA may at least partially correspond to the inactive region NAA-ED of the electronic device ED illustrated in FIG. 1. However, embodiments of the inventive concept are not limited thereto, and unlike the configuration illustrated in FIG. 2 or the like, a portion of the peripheral region NAA may be omitted according to some embodiments. A driving circuit or a driving line for driving the active region AA may be located in the peripheral region NAA.

The peripheral region NAA may include a bending portion BA that is bent with respect to a bending axis BX extending in one direction. Referring to FIG. 3, a bending portion protective layer BPL may be located in the bending portion BA. The bending portion protective layer BPL may protect a circuit layer CL located in the peripheral region NAA. The bending portion protective layer BPL may prevent cracks in components included in the circuit layer CL exposed in the bending portion BA. The bending portion protective layer BPL may be formed by including at least one of an acrylic polymer, a silicone polymer, or an imide polymer. However, embodiments of the inventive concept are not limited thereto.

Meanwhile, unlike the configuration illustrated in FIG. 3, the bending portion protective layer BPL may be connected to or overlap with an edge of the optical layer RCL. In addition, a portion of the optical layer RCL may extend to the bending portion BA and serve as the bending portion protective layer BPL. In addition, according to some embodiments, the bending portion protective layer BPL may be omitted.

According to some embodiments, the display layer DP may be configured to substantially generate or display images by utilizing light emitted from display elements. The display layer DP may be a light-emitting display layer, and for example, the display layer DP may be an organic light-emitting display layer, an inorganic light-emitting display layer, a quantum dot display layer, a micro-LED display layer, or a nano-LED display layer.

The display layer DP may include a base layer BS, a circuit layer CL, a light-emitting element layer EDL, and an encapsulation layer TFE. The encapsulation layer TFE may cover the light-emitting element layer EDL. The encapsulation layer TFE may be located in the active region AA in which the light-emitting element layer EDL is located, and may extend to the peripheral region NAA in which the light-emitting element layer EDL is not located.

According to some embodiments, the base layer BS may be a member or layer that provides a base surface or substrate on which the circuit layer CL is arranged or formed. The base layer BS may be a rigid substrate or may be a flexible substrate capable of bending, folding, rolling, and the like.

The circuit layer CL may be located on the base layer BS. The circuit layer CL may include an insulating layer, a semiconductor pattern, a conductive pattern, a signal line, etc. An insulating layer, a semiconductor layer, and a conductive layer may be formed on the base layer BS by coating, deposition, etc., and then, the insulating layer, the semiconductor layer, and the conductive layer may be selectively patterned by performing a photolithographic process multiple times. Thereafter, a semiconductor pattern, a conductive pattern, and a signal line included in the circuit layer CL may be formed. A configuration, of the circuit layer CL, corresponding to the active region AA and a configuration, of the circuit layer CL, corresponding to the peripheral region NAA may be different from each other. For example, the configuration of the circuit layer CL corresponding to the peripheral region NAA may not include a portion of the configuration of the circuit layer CL corresponding to the active region AA. The circuit layer CL corresponding to the peripheral region NAA may be obtained by removing a portion of the configuration of the circuit layer CL corresponding to the active region AA.

The light-emitting element layer EDL may be located on the circuit layer CL. The light-emitting element layer EDL may include a light-emitting element. For example, the light-emitting element may include an organic light-emitting material, an inorganic light-emitting material, an organic-inorganic light-emitting material, a quantum dot, a quantum rod, a micro-LED, or a nano-LED.

The encapsulation layer TFE may be located on the light-emitting element layer EDL. The encapsulation layer TFE may protect the light-emitting element layer EDL from external contaminants or foreign substances such as moisture, oxygen, and dust particles. The encapsulation layer TFE according to some embodiments will be described in more detail below.

In addition, the display layer DP may further include a support layer PF located under the base layer BS. The support layer PF may have flexibility. The support layer PF may include a polymer film. For example, the support layer PF may include a polyethylene terephthalate (PET) film or the like. The support layer PF may not be located under the base layer BS which corresponds to the bending portion BA.

The sensor layer TP may be located on the display layer DP. The sensor layer TP may sense an external input applied from the outside. The external input may be a user's input. The user's input may include various types of external inputs, such as a portion of the user's body, light, heat, pen, or pressure.

In the display module DM according to some embodiments, the sensor layer TP may be formed on the display layer DP through a continuous process. In this case, it may be expressed that the sensor layer TP is directly located on the display layer DP. The wording "directly located" may mean that a third component is not located between the sensor layer TP and the display layer DP. That is, a separate adhesive member may not be located between the sensor layer TP and the display layer DP. For example, the sensor layer TP may be directly located on the encapsulation layer TFE of the display layer DP. Alternatively, according to some embodiments of the inventive concept, the sensor layer TP may be bonded to the display layer DP through an adhesive member. The adhesive member may include any suitable bonding agent or adhesive.

The optical layer RCL may be located on the sensor layer TP. The optical layer RCL may be located on the display layer DP and control reflected light from the display layer DP by external light. That is, the optical layer RCL may reduce reflectance of external light incident from the outside of the display module DM. The optical layer RCL may include, for example, a polarizing layer or a color filter layer. Meanwhile, unlike the configuration illustrated in the drawings, the optical layer RCL may be omitted in the display module DM according to some embodiments.

The electronic device ED may further include a driving unit DM-M electrically connected to the display module DM. The driving unit DM-M may be electrically connected to the display layer DP and the sensor layer TP. The driving unit DM-M may include a driving chip IC. The driving chip IC may generate or process various electrical signals, and the driving chip IC may be electrically connected to the display layer DP and the sensor layer TP to control the display layer DP and the sensor layer TP.

According to some embodiments, the driving unit DM-M may include a flexible circuit board FB and a driving circuit board MB. The flexible circuit board FB may have one side electrically connected to the display layer DP and the sensor layer TP, and the other side electrically connected to the driving circuit board MB. The driving chip IC may be mounted on the flexible circuit board FB. In this case, the flexible circuit board FB may also be referred to as a chip on film (CoF). In addition, unlike the configuration illustrated, the driving chip IC may be located on the base layer BS of the display module DM.

FIG. 2 illustrates an unfolded state in which the driving unit DM-M is connected to one side of the display module DM, but as illustrated in FIG. 3, in the electronic device ED according to some embodiments, the driving unit DM-M may be bent BD in a direction of the fourth direction axis DR4. Referring to FIGS. 2 and 3, the driving unit DM-M may be bent to overlap the display layer DP.

The electronic device ED according to some embodiments may further include a window WM located on the display module DM. The window WM may cover the entire outside of the display module DM. The window WM may have a shape corresponding to the shape of the display module DM. In the electronic device ED according to some embodiments, the window WM may include an optically transparent insulating material. The window WM may be a glass substrate or a polymer substrate. For example, the window WM may be a tempered glass substrate that has been tempered.

The window WM may be divided into a transmission part TA and a bezel part BZA. The transmission part TA may correspond to the active region AA of the display module DM, and the bezel part BZA may correspond to the peripheral region NAA of the display module DM. The bezel part BZA may define the shape of the transmission part TA. The bezel part BZA may be adjacent to the transmission part TA and may surround the transmission part TA. However, embodiments of the inventive concept are not limited thereto, and the bezel part BZA may be located adjacent to only one side of the transmission part TA, or may be partially omitted.

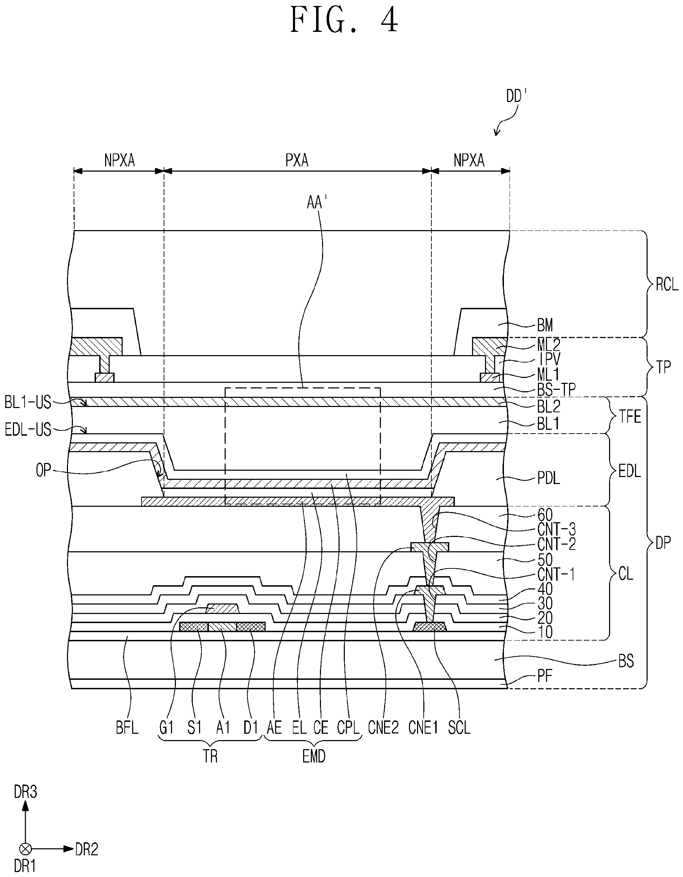

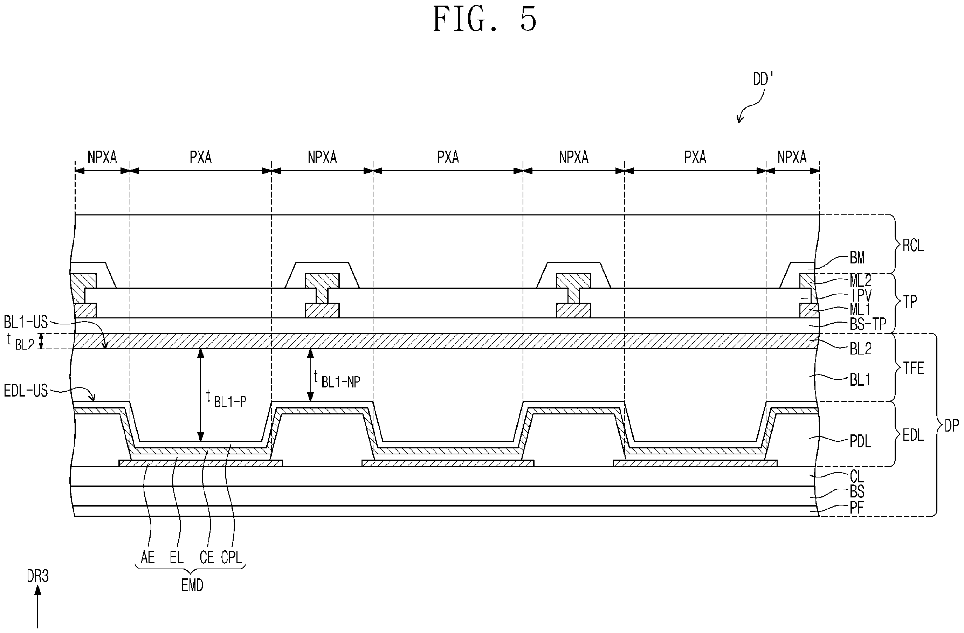

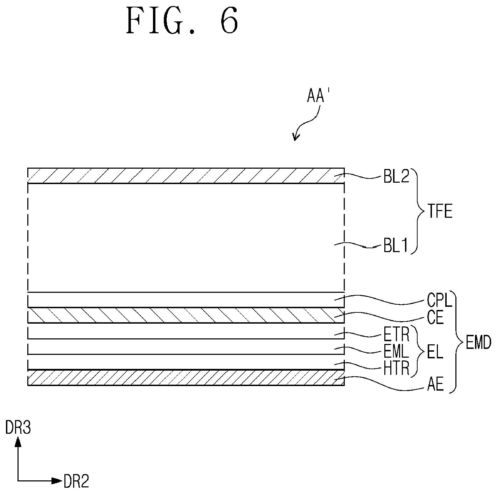

FIG. 4 is a cross-sectional view illustrating a portion corresponding to one light-emitting region in a display module according to some embodiments. FIG. 5 is a cross-sectional view illustrating a portion of a display module according to some embodiments. FIG. 6 is a cross-sectional view illustrating a portion corresponding to a region AA' of FIG. 4.

FIG. 4 illustrates an example of one light-emitting region included in a region DD' of FIG. 2, and may illustrate a portion corresponding to one pixel. FIG. 5 illustrates an example of a plurality of light-emitting regions included in the region DD' of FIG. 2.

Referring to FIGS. 4 to 6, according to some embodiments, the display layer DP may include a base layer BS, a circuit layer CL, a light-emitting element layer EDL, and an encapsulation layer TFE that are sequentially stacked. According to some embodiments, the encapsulation layer TFE may include a first barrier layer BL1 arranged to cover a stepped portion or uneven portion of the light-emitting element layer EDL, and a second barrier layer BL2 located on the first barrier layer BL1.

The base layer BS included in the display layer DP may be a glass substrate, a metal substrate, a polymer substrate, or the like. However, embodiments of the inventive concept are not limited thereto, and the base layer BS may be an inorganic layer, an organic layer, or a composite material layer.

The base layer BS may have a single-layer structure or a multilayer structure. For example, when the base layer BS has a multilayer structure, the base layer BS may have a three-layer structure of a synthetic resin layer, an adhesive layer, and a synthetic resin layer. In particular, the synthetic resin layer may include a polyimide-based resin. In addition, the synthetic resin layer may include at least one of an acrylic resin, a methacrylic resin, a polyisoprene-based resin, a vinyl-based resin, an epoxy-based resin, a urethane-based resin, a cellulose-based resin, a siloxane-based resin, a polyamide-based resin, or a perylene-based resin. Meanwhile, in this specification, "~~-based" resin means including a functional group of"~~".

The circuit layer CL is located on the base layer BS. The circuit layer CL may include a buffer layer BFL. The buffer layer BFL may improve a bonding force between the base layer BS and the semiconductor pattern. The buffer layer BFL may include at least one of a silicon oxide layer, a silicon nitride layer, or a silicon oxynitride layer. For example, the buffer layer BFL may be formed by alternately stacking two or more layers selected from among a silicon oxide layer, a silicon nitride layer, and a silicon oxynitride layer.

The semiconductor pattern may be located on the buffer layer BFL. The semiconductor pattern may include polysilicon. However, embodiments of the inventive concept are not limited thereto, and the semiconductor pattern may include amorphous silicon or metal oxide.

FIG. 4 illustrates only a portion of the semiconductor pattern, and the semiconductor pattern may be further located in another region. The semiconductor pattern may be arranged across the pixels according to a specific rule. The semiconductor pattern may have different electrical characteristics depending on whether the semiconductor pattern is doped or not. The semiconductor pattern may include a first region having high conductivity and a second region having low conductivity. The first region may be doped with an N-type dopant or a P-type dopant. The second region may also be referred to as a channel region.

The first region may have higher conductivity than the second region, and may substantially serve as an electrode or a signal line. The second region may substantially correspond to an active region (or channel) of the transistor. In other words, a portion of the first semiconductor pattern may be an active of the transistor, another portion may be a source or drain of the transistor, and still another portion may be a connection electrode or a connection signal line.

Each of the pixels may have an equivalent circuit including a plurality of transistors, one capacitor, and a light-emitting element, and the equivalent circuit diagram of the pixel may be modified in various forms. FIG. 4 illustrates an example of one transistor TR and a light-emitting element EMD included in a pixel.

The source S1, the active A1, and the drain D1 of the transistor TR may be formed from a semiconductor pattern. The source S1 and the drain D1 may extend in opposite directions from the active A1 on a cross-section. FIG. 4 illustrates a portion of the connection signal line SCL formed from the semiconductor pattern. According to some embodiments, the connection signal line SCL may be electrically connected to the drain D1 of the transistor TR on a plane.

A first insulating layer 10 may be located on the buffer layer BFL. The first insulating layer 10 may overlap, in common, the plurality of pixels and may cover the semiconductor pattern. The first insulating layer 10 may be an inorganic layer and/or an organic layer, and may have a single-layer or multilayer structure. The first insulating layer 10 may include at least one of aluminium oxide, titanium oxide, silicon oxide, silicon nitride, or silicon oxynitride. According to some embodiments, the first insulating layer 10 may be a single-layer silicon oxide layer. Not only the first insulating layer 10 but also an insulating layer of the circuit layer CL to be described later may be an inorganic layer and/or an organic layer, and may have a single-layer or multilayer structure. The inorganic layer may include at least one of the above-described materials, but embodiments of the inventive concept are not limited thereto.

The gate G1 of the transistor TR is located on the first insulating layer 10. The gate G1 may be a portion of the metal pattern. The gate G1 overlaps the active A1. In the process of doping the semiconductor pattern, the gate G1 may function as a mask.

A second insulating layer 20 may be located on the first insulating layer 10 and may cover the gate G1. The second insulating layer 20 may overlap the pixels in common. The second insulating layer 20 may be an inorganic layer and/or an organic layer, and may have a single-layer or multilayer structure including at least one of a silicon oxide layer, a silicon nitride layer, or a silicon oxynitride layer.

A third insulating layer 30 may be located on the second insulating layer 20 and may have a single-layer or multilayer structure including at least one of a silicon oxide layer, a silicon nitride layer, or a silicon oxynitride layer.

A first connection electrode CNE1 may be located on the third insulating layer 30. The first connection electrode CNE1 may be connected to the connection signal line SCL through a contact hole CNT-1 penetrating the first, second, and third insulating layers 10, 20, and 30.

A fourth insulating layer 40 may be located on the third insulating layer 30. The fourth insulating layer 40 may have a single-layer or multilayer structure including at least one of a silicon oxide layer, a silicon nitride layer, or a silicon oxynitride layer. A fifth insulating layer 50 may be located on the fourth insulating layer 40. The fifth insulating layer 50 may be an organic layer.

A second connection electrode CNE2 may be located on the fifth insulating layer 50. The second connection electrode CNE2 may be connected to the first connection electrode CNE1 through a contact hole CNT-2 passing through the fourth insulating layer 40 and the fifth insulating layer 50.

A sixth insulating layer 60 is located on the fifth insulating layer 50 and may cover the second connection electrode CNE2. The sixth insulating layer 60 may be an organic layer.

The light-emitting element layer EDL including the light-emitting element EMD may be located on the circuit layer CL. The light-emitting element layer EDL may include a pixel defining layer PDL and a light-emitting element EMD which includes a functional layer EL located in an opening OP defined in the pixel defining layer PDL.

A top surface EDL-US of the light-emitting element layer EDL may have a step depending on the arrangement of the light-emitting element layer EDL and the pixel defining layer PDL in which the opening OP is defined. That is, the top surface EDL-US of the light-emitting element layer EDL is not flat, and the height of the top surface EDL-US of the light-emitting element layer EDL from the base layer BS in the light-emitting region PXA may be different from that in the non-light-emitting region NPXA. The step caused by the uneven top surface EDL-US of the light-emitting element layer EDL may be covered by the first barrier layer BL1 and thus be planarized.

The light-emitting element EMD may include a first electrode AE, a functional layer EL, and a second electrode CE. The functional layer EL may include the light-emitting layer EML. In addition, the functional layer EL may further include a hole transport region HTR and an electron transport region ETR. The light-emitting element EMD may further include a capping layer CPL. The capping layer CPL may be located on the second electrode CE. When the light-emitting element EMD includes the capping layer CPL, the top surface of the light-emitting element EMD corresponds to the top surface of the capping layer CPL; and when the light-emitting element EMD does not include the capping layer CPL, the top surface of the light-emitting element EMD corresponds to the top surface of the second electrode CE.

The first electrode AE may be located on the sixth insulating layer 60. The first electrode AE may be connected to the second connection electrode CNE2 through the contact hole CNT-3 penetrating the sixth insulating layer 60. The first electrode AE may be a transmissive electrode, a transflective electrode, or a reflective electrode. The first electrode AE may include: at least one selected from among Ag, Mg, Cu, Al, Pt, Pd, Au, Ni, Nd, Ir, Cr, Li, Ca, LiF, Mo, Ti, W, In, Sn, and Zn; a compound of at least two selected from thereamong; a mixture of at least two selected from thereamong; or oxides thereof.

When the first electrode AE is the transmissive electrode, the first electrode AE may include a transparent metal oxide such as indium tin oxide (ITO), indium zinc oxide (IZO), zinc oxide (ZnO), and indium tin zinc oxide (ITZO). When the first electrode AE is the transflective electrode or the reflective electrode, the first electrode AE may include Ag, Mg, Cu, Al, Pt, Pd, Au, Ni, Nd, Ir, Cr, Li, Ca, LiF/Ca (stacked structure of LiF and Ca), LiF/AI (stacked structure of LiF and Al), Mo, Ti, W, a compound thereof, or a mixture thereof (for example, a mixture of Ag and Mg). Alternatively, the first electrode AE may have a multilayer structure including a reflective film or a transflective film formed of the above material, and a transparent conductive film formed of indium tin oxide (ITO), indium zinc oxide (IZO), zinc oxide (ZnO), indium tin zinc oxide (ITZO) or the like. For example, the first electrode AE may include a three-layer structure of ITO/Ag/ITO. However, embodiments of the inventive concept are not limited thereto.

The pixel defining layer PDL may be located on the sixth insulating layer 60 and may cover a portion of the first electrode AE. An opening OP is defined in the pixel defining layer PDL. The opening OP of the pixel defining layer PDL exposes at least a portion of the first electrode AE. According to some embodiments, the light-emitting region PXA is defined to correspond to a partial region of the first electrode AE exposed by the opening OP. The non-light-emitting region NPXA may surround the light-emitting region PXA. According to some embodiments, the pixel defining layer PDL may include a plurality of sub pixel defining layers stacked in a thickness direction.

According to some embodiments, the pixel defining layer PDL may be formed of a polymer resin. For example, the pixel defining layer PDL may be formed of a polyacrylate-based resin or a polyimide-based resin. In addition, the pixel defining layer PDL may further include an inorganic material in addition to the polymer resin. Meanwhile, the pixel defining layer PDL may include a light absorbing material or may include a black pigment or a black dye. The pixel defining layer PDL formed of a black pigment or a black dye may form a black pixel defining layer. Carbon black or the like may be used as a black pigment or a black dye when forming the pixel defining layer PDL, but embodiments of the inventive concept are not limited thereto.

In addition, the pixel defining layer PDL may be formed of an inorganic material. For example, the pixel defining layer PDL may be formed of silicon nitride, silicon oxide, or silicon oxynitride, and the like. The pixel defining layer PDL may define the light-emitting region PXA. The light-emitting region PXA and the non-light-emitting region NPXA may be divided by the pixel defining layer PDL.

The functional layer EL may be located on the first electrode AE. FIGS. 4 and 5 illustrate that the functional layer EL is provided in the opening OP through patterning, but embodiments of inventive concept are not limited thereto. The functional layer EL may be provided as a common layer to overlap the plurality of light-emitting regions PXA and non-light-emitting regions NPXA. In addition, only the light-emitting layer EML included in the functional layer EL is patterned in the opening OP and provided, and the hole transport region HTR and the electron transport region ETR may be provided as a common layer to overlap the plurality of light-emitting regions PXA and non-light-emitting region NPXA.

According to some embodiments, the light-emitting layer EML included in the functional layer EL may be formed separately in each of the light-emitting regions PXA. When the light-emitting layer EML is formed separately in the light-emitting region PXA divided by the pixel defining layer PDL, each of the separated light-emitting layers EML may emit light of at least one color among blue, red, and green. However, embodiments of the inventive concept are not limited thereto, and the light-emitting layer EML may extend to the plurality of light-emitting regions PXA and the non-light-emitting region NPXA and be provided as a common layer. In this case, the light-emitting layer EML may provide blue light or white light. The light-emitting layer EML may include an organic light-emitting material or a quantum dot material.

The hole transport region HTR may be located, in common, in the light-emitting region PXA and the non-light-emitting region NPXA. The hole transport region HTR may include a hole transport layer and may further include a hole injection layer. The electron transport region ETR may be located between the light-emitting layer EML and the second electrode CE. The electron transport region ETR may include an electron transport layer and may further include an electron injection layer. The hole transport region HTR and the electron transport region ETR may be formed as a common layer on the plurality of light-emitting regions PXA. However, embodiments of the inventive concept are not limited thereto, and the hole transport region HTR and the electron transport region ETR may also be patterned to correspond to the light-emitting region PXA.

The light-emitting layer EML may include a fluorescent or phosphorescent material emitting red, green, or blue light. In addition, the light-emitting layer EML may include a metal organic complex as a light-emitting material. Meanwhile, the light-emitting layer EML may include quantum dots as a light-emitting material.

The second electrode CE may be located on the functional layer EL. The second electrode CE may have an integral shape, may extend to the light-emitting region PXA and the non-light-emitting region NPXA, and may be arranged as a common layer. The second electrode CE may include: at least one selected from among Ag, Mg, Cu, Al, Pt, Pd, Au, Ni, Nd, Ir, Cr, Li, Ca, LiF, Mo, Ti, W, In, Sn, and Zn; a compound of at least two selected from thereamong; a mixture of at least two or more selected from thereamong; or oxides thereof.

The second electrode CE may be a transmissive electrode, a transflective electrode or a reflective electrode. When the second electrode CE is the transmissive electrode, the second electrode CE may include a transparent metal oxide, for example, indium tin oxide (ITO), indium zinc oxide (IZO), zinc oxide (ZnO), indium tin zinc oxide (ITZO), etc.

When the second electrode CE is the transflective electrode or the reflective electrode, the second electrode CE may include Ag, Mg, Cu, Al, Pt, Pd, Au, Ni, Nd, Ir, Cr, Li, Ca, LiF/Ca (stacked structure of LiF and Ca), LiF/AI (stacked structure of LiF and Al), Mo, Ti, Yb, and W or a compound including thereof, or a mixture thereof (for example, AgMg, AgYb, or MgAg). Alternatively, the second electrode CE may have a multilayered structure including a reflective film or a transflective film formed of the above-described material and a transparent conductive film formed of indium tin oxide (ITO), indium zinc oxide (IZO), zinc oxide (ZnO), indium tin zinc oxide (ITZO), etc. For example, the second electrode CE may include the above-described metal material, a combination of two or more metal materials selected from the above-described metal materials, or oxides of the above-described metal materials.

According to some embodiments, the light-emitting element EMD may further include a capping layer CPL located on the second electrode CE. The capping layer CPL may include a plurality of layers or a single layer.

According to some embodiments, the capping layer CPL may be an organic layer or an inorganic layer. For example, when the capping layer CPL includes an inorganic material, the inorganic material may include an alkali metal compound such as LiF, an alkaline earth metal compound such as MgF₂, and SiON, SiNₓ, SiOy, etc.

For example, when the capping layer CPL includes an organic material, the organic material may include α-NPD, NPB, TPD, m-MTDATA, Alq₃, CuPc, N4,N4,N4',N4'-tetra(biphenyl-4-yl) biphenyl-4,4'-diamine (TPD15), 4,4',4"-tris(carbazol-9-yl) triphenylamine (TCTA), etc., or includes an epoxy resin, or acrylate such as methacrylate.

The capping layer CPL may function as a buffer layer that protects the functional layer EL located thereunder. The capping layer CPL may have a refractive index of about 1.6 or more. For example, the capping layer CPL may have a refractive index of about 1.9. Because the capping layer CPL may have a refractive index of about 1.9, light extraction efficiency of the light-emitting element layer EDL may be improved.

The encapsulation layer TFE is located on the light-emitting element layer EDL. The encapsulation layer TFE includes a first barrier layer BL1 located on the light-emitting element layer EDL and a second barrier layer BL2 located on the first barrier layer BL1.

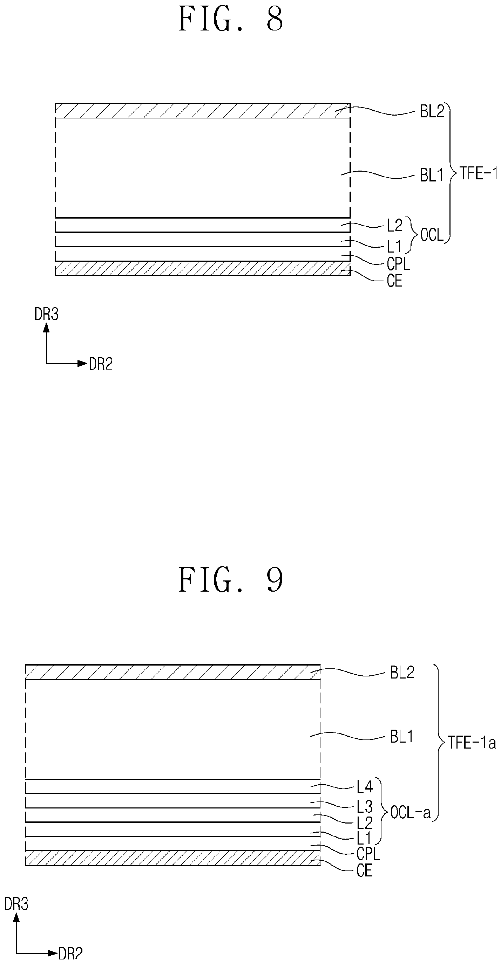

The first barrier layer BL1 may be arranged to cover the step of the light-emitting element layer EDL. The first barrier layer BL1 may function as a planarization layer. In embodiments illustrated in FIG. 4 to 6, etc., the first barrier layer BL1 may be directly arranged on the capping layer CPL. However, embodiments of the inventive concept are not limited thereto, and as described with reference to FIGS. 8 and 9, the encapsulation layer according to some embodiments may further include an optical control layer located under the first barrier layer BL1 and having an average refractive index greater than that of the first barrier layer BL1.

The first barrier layer BL1 includes at least one of silicon oxycarbide or silicon oxide. That is, the first barrier layer BL1 may include Si and O or may include Si, O, and C. When the first barrier layer BL1 includes at least one of silicon oxycarbide or silicon oxide, the content of a C element may be about 0% to about 10% with respect to the total content of the first barrier layer BL1. That is, the first barrier layer BL1 may not include a C element or may include a C element only in a range of about 0% to about 10%. The first barrier layer BL1 may include a Si element in an amount of about 30% to about 50% and an O element in an amount of about 50% to about 60%, with respect to the total content of the first barrier layer BL1.

The first barrier layer BL1 may not contain a C element or contain a C element in an amount of about 10% or less to exhibit high flatness and excellent film-forming characteristics. The first barrier layer BL1 may be formed at a high deposition rate by including a C element in an amount of about 10% or less, and may be formed at a low film-forming temperature of 100 °C or less, so that the first barrier layer BL1 may be formed with high productivity while minimizing damage to the light-emitting element EMD.

The first barrier layer BL1 according to some embodiments may contain at least one of silicon oxycarbide or silicon oxide and may not contain a C element, or contains a C element in an amount of about 10% or less may be formed by a deposition process without a printing (or coating) process, a curing process, and an ashing process required for forming an organic layer used as a planarization layer in an encapsulation layer TFE, so that a manufacturing process time of the encapsulation layer TFE may be relatively reduced and process productivity may be relatively improved.

In addition, according to some embodiments, the first barrier layer BL1 is provided that contains at least one of silicon oxycarbide or silicon oxide and does not contain a C element, or contains a C element in an amount of about 10% or less, in place of a stacked structure of the inorganic layer and the organic layer included in an alternative encapsulation layer, thereby achieving both the barrier function and the planarization function. Accordingly, the encapsulation layer TFE may include one first barrier layer BL1 in place of the stacked structure of the inorganic layer and the organic layer, and thus the light transmittance of the encapsulation layer TFE may be increased.

According to some embodiments, the first barrier layer BL1 may not contain a C element or contain a C element in an amount of about 10% or less to exhibit excellent light transmittance over the entire wavelength of the visible light range. For example, according to some embodiments, the first barrier layer BL1 may exhibit a transmittance of about 100% over the entire wavelength of the visible light range. Accordingly, extraction efficiency of light emitted from the light-emitting element EMD may be improved.

The first barrier layer BL1 may be provided using a chemical vapor deposition (CVD) method. The first barrier layer BL1 may be provided by being deposited on the light-emitting element layer EDL. The first barrier layer BL1 may be deposited to a thickness sufficient to cover the step of the light-emitting element layer EDL so that a top surface BL1-US has a flat surface. According to some embodiments, the top surface BL1-US of the first barrier layer BL1 may have an inclination of 0° to 10° with respect to the base layer BS. For example, the top surface BL1-US of the first barrier layer BL1 may be provided to have an inclination of substantially 0° with respect to the base layer BS, and therefore the first barrier layer BL1 may exhibit high planarization characteristics to cover stepped portions of the layers.

The first barrier layer BL1 may have a thickness of about 1 µm to about 10 µm. For example, a first thickness of the first barrier layer BL1 may be about 3 µm to about 10 µm. The first thickness of the first barrier layer BL1 may be an average value of the thickness t_{BL1-P} in the light-emitting region PXA and the thickness t_{BL1-NP} in the non-light-emitting region NPXA. In addition, according to some embodiments, the first thickness of the first barrier layer BL1 may correspond to an average thickness of the entire first barrier layer BL1 arranged to fill an uneven portion between a component located below the first barrier layer BL1 and the second barrier layer BL2. That is, the first thickness of the first barrier layer BL1 may be an average thickness of a portion located between the light-emitting element layer EDL and the second barrier layer BL2. The first barrier layer BL1 may be deposited to a sufficient thickness of about 1 µm or more thereby achieving both a barrier function and a planarization function.

The first barrier layer BL1 that contains at least one of silicon oxycarbide or silicon oxide may have a refractive index of about 1.45 to about 1.50. The refractive index of the first barrier layer BL1 may be smaller than the refractive index of the second barrier layer BL2. In addition, the refractive index of the first barrier layer BL1 may be smaller than the refractive index of the capping layer CPL of the light-emitting element layer EDL.

The second barrier layer BL2 is located on the first barrier layer BL1. The second barrier layer BL2 may function as a barrier to protect the light-emitting element layer EDL from moisture and oxygen. The second barrier layer BL2 includes at least one of silicon nitride or silicon oxynitride.

A second thickness t_{BL2} of the second barrier layer BL2 may be smaller than the first thickness of the first barrier layer BL1. The second thickness t_{BL2} of the second barrier layer BL2 may be about 1 µm or less. The second barrier layer BL2 may be formed as a flat layer on the top surface BL1-US of the first barrier layer BL1.

The second barrier layer BL2 may be provided using a chemical vapor deposition (CVD) method. The second barrier layer BL2 may be directly deposited and formed on the first barrier layer BL1. The second barrier layer BL2 may be deposited in a chamber different from the chamber in which the first barrier layer BL1 is deposited.

The refractive index of the second barrier layer BL2 that contains at least one of silicon nitride or silicon oxynitride may be about 1.85 to about 1.95. The refractive index of the second barrier layer BL2 may be about 1.89. The refractive index of the second barrier layer BL2 may be greater than that of the first barrier layer BL1.

The display module DM according to some embodiments may include a sensor layer TP located on the display layer DP. The sensor layer TP may be directly located on the second barrier layer BL2. The sensor layer TP may be referred to as a sensor, an input sensing layer, or an input sensing panel. The sensor layer TP may include a sensing base layer BS-TP, a first conductive layer ML1, a sensing insulating layer IPV, and a second conductive layer ML2.

The sensing base layer BS-TP may be directly located on the display layer DP. The sensing base layer BS-TP may be an inorganic layer including at least one of silicon nitride, silicon oxynitride, or silicon oxide. Alternatively, the sensing base layer BS-TP may be an organic layer including an epoxy resin, an acrylic resin, or an imide-based resin. The sensing base layer BS-TP may have a single-layer structure or a multilayer structure in which layers are stacked along the third direction axis DR3.

Each of the first conductive layer ML1 and the second conductive layer ML2 may have a single-layer structure or a multilayer structure in which layers are stacked along the third direction axis DR3. A conductive layer having a single-layer structure may include a metal layer or a transparent conductive layer. The metal layer may include molybdenum, silver, titanium, copper, aluminium, or an alloy thereof. A transparent conductive layer may include a transparent conductive oxide such as indium tin oxide (ITO), indium zinc oxide (IZO), zinc oxide (ZnO), zinc peroxide (ZnO₂), or indium zinc tin oxide (IZTO). In addition, the transparent conductive layer may include a conductive polymer such as PEDOT, metal nanowires, graphene, and the like.

A conductive layer having a multilayer structure may include metal layers. The metal layers may have, for example, a three-layer structure of titanium/aluminium/titanium. The conductive layer having a multilayer structure may include at least one metal layer and at least one transparent conductive layer.

The sensing insulating layer IPV may be located between the first conductive layer ML1 and the second conductive layer ML2. The sensing insulating layer IPV may include an inorganic film. The inorganic film may include at least one of aluminium oxide, titanium oxide, silicon oxide, silicon nitride, silicon oxynitride, zirconium oxide, or hafnium oxide.

Alternatively, the sensing insulating layer IPV may include an organic film. The organic film may include at least one of an acrylic resin, a methacrylic resin, polyisoprene, a vinyl-based resin, an epoxy-based resin, a urethane-based resin, a cellulose-based resin, a siloxane-based resin, a polyimide-based resin, a polyamide-based resin, or a perylene-based resin.

According to some embodiments, the optical layer RCL may be located on the sensor layer TP. For example, the optical layer RCL may be formed on the sensor layer TP through a continuous process. However, embodiments of the inventive concept are not limited thereto. The optical layer RCL may include a pigment or a dye. In addition, according to some embodiments, the optical layer RCL may include a plurality of filter units that transmit light in different wavelength ranges. The filter units that transmit light in different wavelength ranges may be arranged to respectively correspond the light-emitting regions PXA divided by the non-light-emitting region NPXA.

The optical layer RCL may further include a division layer BM. A material constituting the division layer BM is not particularly limited as long as the material absorbs light. The division layer BM has a black color, and according to some embodiments of the inventive concept, the division layer BM may contain a black coloring agent. The black coloring agent may contain a black dye or a black pigment. The black coloring agent may contain carbon black, a metal such as chromium, or an oxide thereof.

The division layer BM may cover the second conductive layer ML2 of the sensor layer TP. The division layer BM may prevent reflection of external light by the second conductive layer ML2.

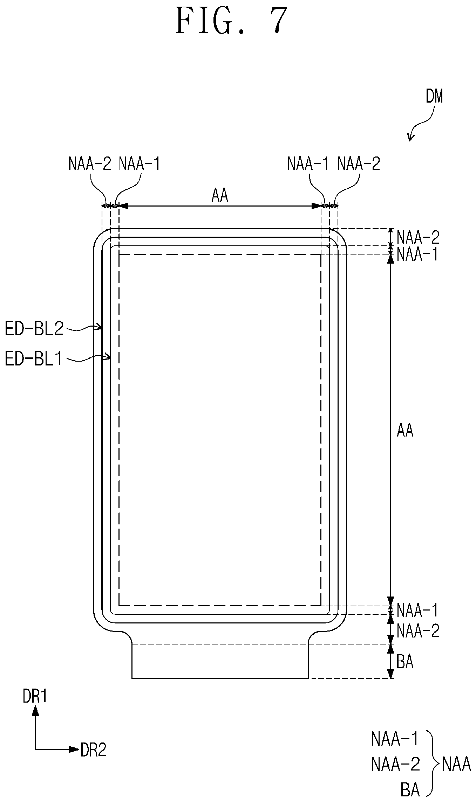

FIG. 7 is a plan view of a display module according to some embodiments. FIG. 7 illustrates a plane parallel to a plane defined by the first direction axis DR1 and the second direction axis DR2, and the plane defined by the first direction axis DR1 and the second direction axis DR2 may be a plane parallel to the base layer BS (FIG. 3). The display module DM may include an active region AA and a peripheral region NAA located outside the active region AA, and the peripheral region NAA may include a first peripheral region NAA-1 adjacent to the active region AA and a second peripheral region NAA-2 spaced apart from the active region AA. In addition, the peripheral region NAA may include a bending portion BA extending from at least one side surface of the second peripheral region NAA-2.

When seen in a plan view, an area of the second barrier layer may be larger than an area of the first barrier layer. The second barrier layer and the first barrier layer may be arranged to cover the entire active region AA and extend to a portion of the peripheral region NAA. The first barrier layer and the second barrier layer are formed by being respectively deposited in different chambers, and accordingly, an edge ED-BL1 of the first barrier layer and an edge ED-BL2 of the second barrier layer may not coincide with each other.

The edge ED-BL1 of the first barrier layer and the edge ED-BL2 of the second barrier layer may be located in the peripheral region NAA. The edge ED-BL1 of the first barrier layer may be located in the first peripheral region NAA-1, and the edge ED-BL2 of the second barrier layer may be located in the second peripheral region NAA-2. That is, when seen in a plan view, the edge ED-BL2 of the second barrier layer may be located outside the edge ED-BL1 of the first barrier layer.

FIGS. 8 and 9 are cross-sectional views each illustrating a portion of a display module according to some embodiments. FIGS. 8 and 9 each illustrate embodiments having a configuration different from that of the encapsulation layer illustrated in FIG. 6, etc., and may be cross-sectional views illustrating a portion corresponding to the region AA' of FIG. 4.

Referring to FIG. 8, the encapsulation layer TFE-1 included in the display module according to some embodiments may further include an optical control layer OCL located under the first barrier layer BL1. The optical control layer OCL may be located between the light-emitting element layer EDL (FIG. 5) and the first barrier layer BL1.

The optical control layer OCL may include at least two inorganic layers L1 and L2. The encapsulation layer TFE-1 according to some embodiments may include two or more inorganic layers L1 and L2 having different refractive indices. One of the two inorganic layers L1 or L2 may be a low-refractive layer including silicon oxynitride, and the other may be a high-refractive layer including silicon nitride. Because the encapsulation layer TFE-1 includes the optical control layer OCL in which inorganic layers L1 and L2 having different refractive indices are stacked, and the light extraction efficiency of the light-emitting element EMD (FIG. 5) in the display module DM according to some embodiments may be increased and the deviation of display quality according to the viewing angle may be reduced. For example, according to some embodiments, a first inorganic layer L1 having a relatively low refractive index may be directly located on the capping layer CPL, and a second inorganic layer L2 having a relatively high refractive index compared to the first inorganic layer L1 may be directly located on the first inorganic layer L1. The first barrier layer BL1 may be directly located on the second inorganic layer L2. According to some embodiments, the first inorganic layer L1, the second inorganic layer L2, and the first barrier layer BL1 may be provided by being successively deposited in the same chamber.

Referring to FIG. 9, an encapsulation layer TFE-1a included in the display module according to some embodiments may include an optical control layer OCL-a including a plurality of inorganic layers L1, L2, L3, and L4. In the optical control layer OCL-a, a relatively low refractive inorganic layer and a relatively high refractive inorganic layer may be alternately arranged.

According to some embodiments, the optical control layer OCL-a may include a first inorganic layer L1 having a first refractive index, a second inorganic layer L2 located on top of the first inorganic layer L1 and having a second refractive index greater than the first refractive index, a third inorganic layer L3 located on top of the second inorganic layer L2 and having a third refractive index smaller than the second refractive index, and a fourth inorganic layer L4 located on top of the third inorganic layer L3 and having a fourth refractive index smaller than the third refractive index. For example, the optical control layer OCL-a may include the first inorganic layer L1 having a refractive index of about 1.35 to about 1.50, the second inorganic layer L2 having a refractive index of about 1.85 to about 1.95, the third inorganic layer L3 having a refractive index of about 1.65 to about 1.75, and the fourth inorganic layer L4 having a refractive index of about 1.50.

The first inorganic layer L1 may include silicon oxynitride, the second inorganic layer L2 may include silicon nitride, and the third inorganic layer L3 and the fourth inorganic layer L4 each may include silicon oxynitride.

According to some embodiments, the first inorganic layer L1 has a thickness of about 1000 Å to about 2000 Å, the second inorganic layer L2 has a thickness of about 5000Å to about 10000Å, the third inorganic layer L3 has a thickness of about 500Å to about 1500Å, and the fourth inorganic layer L4 has a thickness of about 500Å to about 1500Å.

However, embodiments of the inventive concept are not limited thereto, and a stacking order of the plurality of stacked inorganic layers L1, L2, L3, and L4, refractive index ranges of the stacked inorganic layers L1, L2, L3, and L4, and thickness ranges of the plurality of inorganic layers L1, L2, L3, and L4 may be changed in various combinations according to the display quality characteristics required for the display module.

According to some embodiments of the inventive concept, when the light-emitting element EMD (FIG. 5) includes the capping layer CPL, the first inorganic layer L1 may be directly located on the capping layer CPL, and the refractive index of the first inorganic layer L1 may be smaller than that of the capping layer CPL. A light path is changed according to a difference in refractive index between the first inorganic layer L1 and the capping layer CPL, and thus, the non-uniform display quality due to the viewing angle of the display module may be reduced.

The second inorganic layer L2 may be directly deposited on the first inorganic layer L1. The second inorganic layer L2 has a larger refractive index than the first inorganic layer L1, and an optical resonance phenomenon occurs in the optical control layer OCL-a due to the difference in refractive index between the first inorganic layer L1 and the second inorganic layer L2, so that the light extraction efficiency in the display module may be increased. In addition, the light path of light emitted from the light-emitting element EMD is changed due to a difference in refractive index between the first inorganic layer L1 and the second inorganic layer L2, and resultantly, according to some embodiments, the non-uniformity of display quality due to the viewing angle may be reduced.

The third inorganic layer L3 located on the second inorganic layer L2 may have a refractive index lower than that of the second inorganic layer L2. An optical resonance phenomenon may occur in the optical control layer OCL-a due to a difference in refractive index between the second inorganic layer L2 and the third inorganic layer L3, and accordingly, light extraction efficiency may be improved, and the non-uniformity of display quality due to the viewing angle may be reduced.

The fourth inorganic layer L4 may be located between the third inorganic layer L3 and the first barrier layer BL1. The fourth inorganic layer L4 may reduce a difference in refractive index between the third inorganic layer L3 and the first barrier layer BL1. The refractive index of the fourth inorganic layer L4 may be smaller than that of the third inorganic layer L3 and greater than the refractive index of the first barrier layer BL1. The fourth inorganic layer L4 minimizes a difference in refractive index between the third inorganic layer L3 and the first barrier layer BL1. Accordingly, light extraction efficiency may be improved by minimizing light reflection occurring at the boundary between the optical control layer OCL-a and the first barrier layer BL1.

The optical control layer OCL and OLC-a and the first barrier layer BL1, which are included in the encapsulation layer TFE-1 and TFE-1a according to some embodiments illustrated in FIGS. 8 and 9, may be successively deposited and formed in the same chamber. Accordingly, compared to manufacturing of an alternative encapsulation layer using an organic layer as a planarization layer, the manufacturing time for the encapsulation layers TFE-1 and TFE-1a according to some embodiments may be shortened, thereby improving process productivity.

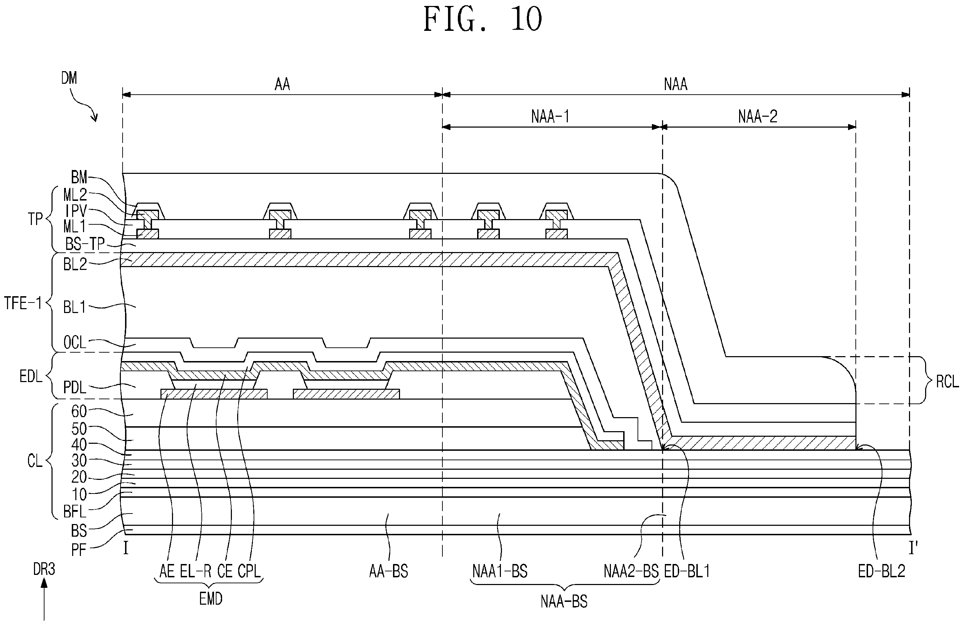

FIG. 10 is a cross-sectional view illustrating a portion of a display module according to some embodiments. FIG. 10 may be a cross-sectional view taken along line I-I' of FIG. 2. FIG. 10 illustrates embodiments having an encapsulation layer TFE-1 including an optical control layer OCL, a first barrier layer BL1, and a second barrier layer BL2. However, according to some embodiments of the inventive concept is not limited thereto, and according to some embodiments, the optical control layer OCL may be omitted and the first barrier layer BL1 may be directly located on the light-emitting element layer EDL.

Referring to FIG. 10, an edge of the encapsulation layer TFE-1 may be located in the peripheral region NAA of the display module DM. The edge ED-BL1 of the first barrier layer BL1 of the encapsulation layer TFE-1 may be located in the first peripheral region NAA-1, and the edge ED-BL2 of the second barrier layer BL2 may be located in the second peripheral region NAA-2.

The base layer BS may be divided into an active region AA-BS and a peripheral region NAA-BS. The active region AA-BS of the base layer BS corresponds to the active region AA of the display module DM, and the peripheral region NAA-BS of the base layer BS corresponds to the peripheral region NAA of the display module DM.

The base layer BS may include the active region AA-BS and the peripheral region NAA-BS, and the peripheral region NAA-BS of the base layer BS may include a first peripheral portion NAA1-BS and a second peripheral portion NAA2-BS. The active region AA-BS of the base layer BS may overlap the light-emitting element layer EDL. The peripheral region NAA-BS of the base layer BS may not overlap the light-emitting element layer EDL. In the peripheral region NAA-BS, the first peripheral portion NAA1-BS may be adjacent to the active region AA-BS, and the second peripheral portion NAA2-BS may be spaced apart from the active region AA-BS.

The first peripheral portion NAA1-BS of the base layer BS may overlap the first barrier layer BL1 and the second barrier layer BL2. In addition, the second peripheral portion NAA2-BS of the base layer BS may not overlap the first barrier layer BL1 and may overlap the second barrier layer BL2.

Meanwhile, unlike the configuration illustrated in FIG. 10, an edge of the optical control layer OCL may overlap the edge ED-BL1 of the first barrier layer BL1. That is, the optical control layer OCL and the first barrier layer BL1 may be successively deposited in the same chamber and simultaneously patterned using one mask.

The circuit layer CL arranged to correspond to the peripheral region NAA may be obtained by removing a portion of the configuration of the circuit layer CL corresponding to the active region AA. Compared to the active region AA, the second peripheral region NAA-2 may be obtained by removing a portion of the configuration of the circuit layer CL in the active region AA, and the circuit layer CL in the second peripheral region NAA-2 may include a plurality of stacked insulating layers 10, 20, 30, and 40.

Some of the insulating layers 10, 20, 30, and 40 included in the circuit layer CL may be stacked and located on the second peripheral portion NAA2-BS of the base layer BS, and the second barrier layer BL2 may be directly located on the uppermost layer among the insulating layers 10, 20, 30, and 40 in a portion overlapping the second peripheral portion NAA2-BS.

According to some embodiments, the first barrier layer BL1 is formed by a deposition process, and a dam, which would be introduced in an alternative encapsulation layer to control the flow of the organic layer included as the planarization layer, may be omitted. That is, in the display module DM according to some embodiments, a fifth insulating layer 50, a sixth insulating layer 60, or the pixel defining layer PDL are formed through the same process, and a dam which would be formed to protrude on the insulating layers 10, 20, 30, and 40 in the peripheral region NAA may be omitted.

FIG. 11 is a cross-sectional image of a test sample provided with a test inorganic film having a configuration of a first barrier layer according to some embodiments of the inventive concept. FIG. 11 shows an image of a sample in which a test inorganic layer BL1-EX having a film configuration of the first barrier layer according to the inventive concept is arranged to cover a silicon oxide pattern PT formed on the base substrate BSP.

The test inorganic layer BL1-EX may cover the plurality of silicon oxide patterns PT and may be formed while filling a space between the silicon oxide patterns PT. In addition, a top surface EX-US of the test inorganic layer BL1-EX may be a flat surface. It may be confirmed that the test inorganic layer BL1-EX having a barrier layer according to some embodiments that contains at least one of silicon oxycarbide or silicon oxide and contains a C element in an amount of about 0% to about 10% exhibits excellent planarization characteristics. In addition, it may be confirmed that the test inorganic layer BL1-EX has a thickness H_{PT} of about 3 µm, a width W_{PT} of about 2 µm, and sufficiently covers the patterns PT having a spaced distance therebetween of about 2 µm or less. That is, it may be confirmed that the first barrier layer according to some embodiments of the inventive concept that contains at least one of silicon oxycarbide or silicon oxide and contains 0% to about 10% of a C element exhibits excellent planarization characteristics while sufficiently covering a stepped portion located under the first barrier layer.

An electronic device according to some embodiments may include a barrier layer that contains at least one of silicon oxycarbide or silicon oxide, and contains a C element in an amount of about 0% to about 10% with respect to the total content, in the encapsulation layer, and thus exhibit relatively improved light efficiency and relatively improved viewing angle display quality. In addition, the electronic device according to some embodiments may include, in the encapsulation layer, a barrier layer that contains at least one of silicon oxycarbide or silicon oxide, and contains a C element in an amount of about 0% to about 10% with respect to the total content, and a manufacturing process time is reduced compared to an alternative electronic device including an organic layer in the encapsulation layer. Accordingly, the electronic device according to some embodiments may be manufactured with relatively high process productivity.

An electronic device according to some embodiments includes a barrier layer having a relatively low carbon content as an encapsulation layer and which may achieve a planarization function and a barrier function, thereby exhibiting relatively improved light extraction efficiency characteristics.

In addition, a barrier layer constituting an encapsulation layer included in the electronic device according to some embodiments is provided through a deposition process, and as compared to an alternative manufacturing process of the encapsulation layer including an organic layer, the process time may be shortened, and thus the manufacturing productivity of the electronic device may be improved.

Although the embodiments of the inventive concept have been described, it is understood that the present invention should not be limited to these embodiments but various changes and modifications can be made by one ordinary skilled in the art within the scope of the inventive concept as hereinafter claimed.

## Claims

1. An electronic device comprising:
a base layer;
a circuit layer on the base layer;
a light-emitting element layer on the circuit layer; and
an encapsulation layer including a first barrier layer on the light-emitting element layer and having at least one of silicon oxycarbide or silicon oxide, and a second barrier layer on top of the first barrier layer and having at least one of silicon oxynitride or silicon nitride,
wherein a content of a Carbon (C) element is in a range of 0% to 10% with respect to a total content of the first barrier layer.

2. The electronic device of claim 1, wherein a first thickness of the first barrier layer is greater than a second thickness of the second barrier layer.

3. The electronic device of claim 2, wherein the first thickness is in a range of 3 µm to 10 µm.

4. The electronic device of any one of claims 1 to 3, wherein with respect to the total content of the first barrier layer, a Silicon (Si) element is included in an amount in a range of 30% to 50%, and an Oxygen (O) element is included in an amount in a range of 50% to 60%.

5. The electronic device of any one of claims 1 to 4, wherein when seen in a plan view parallel to the base layer, an edge of the second barrier layer is outside an edge of the first barrier layer.

6. The electronic device of any one of claims 1 to 5, wherein in a plan view, an area of the second barrier layer is larger than an area of the first barrier layer.

7. The electronic device of any one of claims 1 to 6, wherein a refractive index of the second barrier layer is greater than a refractive index of the first barrier layer.

8. The electronic device of any one of claims 1 to 7, wherein the encapsulation layer further comprises an optical control layer between the light-emitting element layer and the first barrier layer, and having two or more inorganic layers having different refractive indices.

9. The electronic device of claim 8, wherein the optical control layer comprises:
a first inorganic layer including silicon oxynitride and having a first refractive index;
a second inorganic layer on top of the first inorganic layer, including silicon nitride, and having a second refractive index greater than the first refractive index;
a third inorganic layer on top of the second inorganic layer, including silicon oxynitride, and having a third refractive index smaller than the second refractive index; and
a fourth inorganic layer on top of the third inorganic layer, including silicon oxynitride, and having a fourth refractive index smaller than the third refractive index.

10. The electronic device of claim 8 or claim 9, wherein the optical control layer and the first barrier layer are successively deposited in a same chamber, and
the second barrier layer and the first barrier layer are deposited in different chambers.

11. The electronic device of any one of claims 1 to 10, wherein the light-emitting element layer comprises a pixel defining layer and a light-emitting element including a functional layer in an opening defined in the pixel defining layer, and
the first barrier layer covers a top surface of the light-emitting element layer.

12. The electronic device of claim 11, wherein a top surface of the first barrier layer is a flat surface, and the first barrier layer fills a space between the light-emitting element layer and the second barrier layer.

13. The electronic device of any one of claims 1 to 12, further comprising a sensor layer on the encapsulation layer,
wherein the sensor layer is directly on the second barrier layer.

14. The electronic device of any one of claims 1 to 13, wherein the base layer includes an active region overlapping the light-emitting element layer; and a peripheral region adjacent to the outside of the active region and non-overlapping the light-emitting element layer,
the peripheral region includes a first peripheral portion adjacent to the active region, and a second peripheral portion spaced apart from the active region and adjacent to the first peripheral portion,
the first peripheral portion overlaps the first barrier layer and the second barrier layer, and
the second peripheral portion does not overlap the first barrier layer and overlaps the second barrier layer.

15. The electronic device of claim 14, wherein a plurality of insulating layers included in the circuit layer are stacked and on the second peripheral portion, and
the second barrier layer is directly on the uppermost layer of the plurality of insulating layers in the second peripheral portion.
